(19) **Europäisches Patentamt**
**European Patent Office**
**Office européen des brevets**

(11) **EP 3 447 811 B1**

(12) **EUROPEAN PATENT SPECIFICATION**

(45) Date of publication and mention
of the grant of the patent:
**13.05.2020 Bulletin 2020/20**

(21) Application number: **18160917.3**

(22) Date of filing: **09.03.2018**

(51) Int Cl.:
*H01L 35/16* (2006.01)   *H01L 35/18* (2006.01)
*H01L 35/22* (2006.01)   *H01L 35/26* (2006.01)

(54) **THERMOELECTRIC CONVERSION DEVICE AND THERMOELECTRIC CONVERSION MODULE**

VORRICHTUNG FÜR THERMOELEKTRISCHE UMWANDLUNG UND MODUL FÜR
THERMOELEKTRISCHE UMWANDLUNG

DISPOSITIF DE CONVERSION THERMOÉLECTRIQUE ET MODULE DE CONVERSION
THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2017 JP 2017065842**

(43) Date of publication of application:
**27.02.2019 Bulletin 2019/09**

(73) Proprietor: **Hitachi, Ltd.**
**Chiyoda-ku**
**Tokyo 100-8280 (JP)**

(72) Inventors:
• **YABUUCHI, Shin**
**Tokyo, 100-8280 (JP)**

• **KUROSAKI, Yosuke**
**Tokyo, 100-8280 (JP)**
• **NISHIDE, Akinori**
**Tokyo, 100-8280 (JP)**
• **HAYAKAWA, Jyun**
**Tokyo, 100-8280 (JP)**

(74) Representative: **Strehl Schübel-Hopf & Partner**
**Maximilianstrasse 54**
**80538 München (DE)**

(56) References cited:
**WO-A1-2007/108147    JP-A- 2012 104 558
US-A- 6 060 657    US-A1- 2003 099 279
US-A1- 2007 028 956**

**Description**

BACKGROUND OF THE INVENTION

1. Field of the Invention

The present invention relates to a thermoelectric conversion device, and a thermoelectric conversion module.

2. Description of Related Art

A thermoelectric conversion device has long been known as a technique that converts exhaust heat energy into power. For example, $Bi_2Te_3$ has been put to actual application as a thermoelectric conversion material capable of producing the Seebeck effect relatively efficiently at temperatures of 200°C and less. Thermoelectric conversion materials, such as the Bi-Te-based material above, capable of producing high Seebeck effect in the vicinity of room temperature also have use as a cooling device that takes advantage of the Peltier effect.

The performance of a thermoelectric conversion material is typically evaluated with dimensionless figure of merit (ZT) . The dimensionless figure of merit increases with increasing values of Seebeck coefficient S and electrical conductivity $\sigma$, and with decreasing values of thermal conductivity $\kappa$. It is, however, difficult to choose a material that can satisfy low thermal conductivity and high Seebeck coefficient at the same time, and there is only a few materials that can satisfy this condition.

For example, the Bi-Te-based material has high conversion efficiency with a thermoelectric figure of merit ZT of greater than 1. However, Bi and Te are both expensive, and Te is highly toxic. There accordingly is a need for a high-efficiency thermoelectric conversion material that can replace $Bi_2Te_3$ as a material that can be mass produced at low cost, and that is more environmentally friendly.

For example, JP-A-2012-104558 discloses a thermoelectric conversion material using $Mg_2Si$, specifically a silicide semiconductor configured from inexpensive and nontoxic elements. JP-A-2004-253618 discloses a thermoelectric conversion material of a Heusler alloy-type crystalline structure configured from environmentally friendly, inexpensive elements such as Fe, V, and Al.

US 2003/0099279 A1 discloses a thermoelectric material based on a BiTe/SbTe superlattice strucure.

Unlike the Bi-Te-based material, the thermoelectric conversion materials described in these publications do not contain toxic rare metals, and are industrially useful. However, these thermoelectric conversion materials are not necessarily superior to the Bi-Te-based material in terms of thermoelectric conversion characteristic, and there is a need for a thermoelectric conversion material having higher thermoelectric conversion performance.

SUMMARY OF THE INVENTION

It is accordingly an object of the present invention to provide a thermoelectric conversion device and a thermoelectric conversion module that are environmentally friendly and can be produced at low cost, and that are capable of producing a high thermoelectric conversion characteristic.

In a preferred embodiment, a thermoelectric conversion device according to the present invention includes:

a first material represented by composition formula $AB_x$ (wherein A is at least one element selected from the group consisting of Li, Na, K, Rb, Cs, Mg, Ca, Sr, Ba, Sc, Y, La, Bi, He, Ne, Ar, Kr, and Xe, and B is at least one element selected from the group consisting of Zn, Cu, Ag, Au, Al, Ga, In, Si, Ge, and Sn), and having a lattice thermal conductivity that is lower than its electron thermal conductivity; and
a second material having a higher Seebeck coefficient than the first material, and an electron thermal conductivity that is lower than its lattice thermal conductivity,
wherein the lattice thermal conductivity of the first material is lower than the lattice thermal conductivity of the second material, and
wherein the distance from the interface between the first material and the second material to an end portion of the first material and to an end portion of the second material is 500 nm or less.

A preferred embodiment of a thermoelectric conversion module according to the present invention is a thermoelectric conversion module that includes a plurality of thermoelectric conversion devices, and an electrode electrically connecting between the thermoelectric conversion devices,
wherein the plurality of thermoelectric conversion devices each represent the thermoelectric conversion device of the embodiment above.

The present invention enables providing a thermoelectric conversion device and a thermoelectric conversion module that are environmentally friendly and can be produced at low cost, and that are capable of producing a high thermoelectric conversion characteristic.

BRIEF DESCRIPTION OF THE DRAWINGS

FIG. 1 is an explanatory diagram of a model joining a first material and a second material.
FIG. 2 is a diagram representing the result of a simulation of the electron temperature and the lattice temperature in each material region of a joined unit of a metallic material and a semiconductor material.
FIG. 3 is a diagram representing the result of a simulation of the electron temperature and the lattice temperature in each material region of a joined unit of a metallic material and a semiconductor material.
FIG. 4 is a diagram showing a $NaZn_{13}$-type crystalline structure.
FIG. 5A shows diagrams representing the relationship between the density of states and the energy of compounds having a $NaZn_{13}$-type crystalline structure.
FIG. 5B shows diagrams representing the relationship between the density of states and the energy of compounds having a $NaZn_{13}$-type crystalline structure.
FIG. 6 is a diagram representing the result of calculations of the relationship between the lattice thermal conductivity of $BaCu_{13}$ and temperature.
FIG. 7 shows diagrams representing a $BaCd_{11}$-type crystalline structure.
FIG. 8 shows diagrams representing a $Mg_2Zn_{11}$-type crystalline structure.
FIG. 9 shows diagrams representing a $Na_4Si_{23}$-type crystalline structure.
FIG. 10 shows diagrams representing a $CaCu_5$-type crystalline structure.
FIG. 11 shows diagrams representing a $MgCu_2$-type crystalline structure.
FIGS. 12A to 12C are diagrams schematically showing a cross section of a thermoelectric conversion device having a multilayer structure.
FIGS. 13A and 13B show perspective views of a thermoelectric conversion device having a two-dimensional lattice structure.
FIG. 14 is a diagram schematically showing a configuration of a nanoparticle complex.
FIGS. 15A and 15B show perspective views of a thermoelectric conversion module according to an embodiment.
FIGS. 16A to 16E are diagrams describing a method for producing a thermoelectric conversion nanowire.
FIG. 17 is a perspective view showing an application example of a thermoelectric conversion nanowire.
FIG. 18 is a perspective view showing an application example of a thermoelectric conversion nanowire.
FIG. 19 is a perspective view showing an application example of a thermoelectric conversion nanowire.

DESCRIPTION OF THE PREFERRED EMBODIMENTS

A thermoelectric conversion device of an embodiment includes a first material and a second material that differ from each other with respect to the primary component of the heat carrier, and is configured as a joined unit of the first material and the second material. In the thermoelectric conversion device of the embodiment, the first material and the second material used have lattice thermal conductivities and electron thermal conductivities that satisfy the predetermined relationships described below, and are joined to each other to provide a high thermoelectric conversion characteristic.

The thermoelectric conversion characteristic is described below. The performance of a thermoelectric conversion material is evaluated using the dimensionless figure of merit (ZT) represented by the following formula (1) .

$$Z = \frac{\sigma S^2}{\kappa} \qquad \cdots (1)$$

In the formula (1), $\sigma$ is the electrical conductivity, S is the Seebeck coefficient, and $\kappa$ is the thermal conductivity. When the heat carrier is a combination of electrons and a lattice, the thermal conductivity $\kappa$ is represented as a sum of the electron thermal conductivity $\kappa_e$ contributed by the electrons, and the lattice thermal conductivity $\kappa_p$ contributed by the lattice, specifically $\kappa = \kappa_e + \kappa_p$. The dimensionless figure of merit (ZT) is obtained by multiplying the both sides of the formula (1) by temperature T. In the formula (1), ZT increases with increasing values of Seebeck coefficient S and electrical conductivity $\sigma$, and with decreasing values of thermal conductivity $\kappa$. Higher thermoelectric conversion performance can be obtained with higher values of ZT.

In studying traditional thermoelectric conversion materials, the present inventors found that a high thermoelectric conversion characteristic can be obtained when a first material (described later) is combined with a material which, despite a high power factor $\sigma S^2$ (i.e., Seebeck coefficient S, and electrical conductivity $\sigma$), is thought to exhibit only limited thermoelectric conversion performance because of high lattice thermal conductivity $\kappa$.

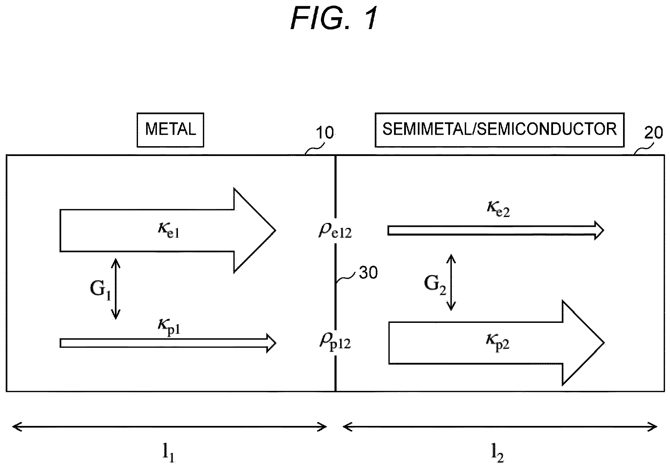

The following describes the thermal resistance R of when the first material and the second material are joined to each other, with reference to FIG. 1. FIG. 1 schematically shows a joined unit in which a first material 10, which is a metallic material with length $l_1$, is joined to a second material 20, which is a semiconductor or a semimetallic material with length $l_2$ at a joint interface 30.

The total thermal resistance R of the joined unit shown in FIG. 1 can be represented by the following formula (2).

$$R = \frac{l_1}{\kappa_{e1} + \kappa_{p1}} + \frac{l_2}{\kappa_{e2} + \kappa_{p2}} + \frac{\alpha_e \alpha_p}{\alpha} - \frac{d_1}{\kappa_{e1} + \kappa_{p1}} \tanh(l_1/d_1) - \frac{d_2}{\kappa_{e2} + \kappa_{p2}} \tanh(l_2/d_2)$$

$$\cdots (2)$$

In the formula (2), $\kappa_{e1}$ is the electron thermal conductivity of the metallic material, $\kappa_{p1}$ is the lattice thermal conductivity of the metallic material, $\kappa_{e2}$ is the electron thermal conductivity of the semiconductor material, and $\kappa_{p2}$ is the lattice thermal conductivity of the semiconductor material. In the formula (2), $\alpha$, $\alpha_e$, $\alpha_p$, $d_1$, and $d_2$ are represented by the following formulae (3) to (8).

$$\frac{1}{\kappa_{ai}} = \frac{1}{\kappa_{ei}} + \frac{1}{\kappa_{pi}} \qquad \cdots (3)$$

$$d_i^2 = \frac{\kappa_{ai}}{G_i} \qquad \cdots (4)$$

$$t_{xi} = \frac{d_i}{\kappa_{xi}} \tanh(\frac{l_i}{d_i}) \qquad \cdots (5)$$

$$\alpha = \rho_{e12} + \rho_{p12} + t_{a1} + t_{a2} \qquad \cdots (6)$$

$$\alpha_e = \rho_{e12} + t_{e1} + t_{e2} \qquad \cdots (7)$$

$$\alpha_p = \rho_{p12} + t_{p1} + t_{p2} \qquad \cdots (8)$$

In the formulae (3) to (8), i = 1 or 2, x represents e, p, or a, and $G_i$ represents the electron-lattice coupling factor (electro-phonon coupling factor) of the metal or the semiconductor. In the formulae (3) to (8), $\rho_{p12}$ represents the interfacial thermal resistance of a lattice, and $\rho_{e12}$ represents the interfacial thermal resistance of electrons.

From the formula (2), the effective thermal conductivity $\kappa_{eff}$ of the complex system of length ($l_1 + l_2$) can be represented by the following formula (9).

$$\kappa_{\text{eff}} = \frac{l_1 + l_2}{R} \qquad \cdots (9)$$

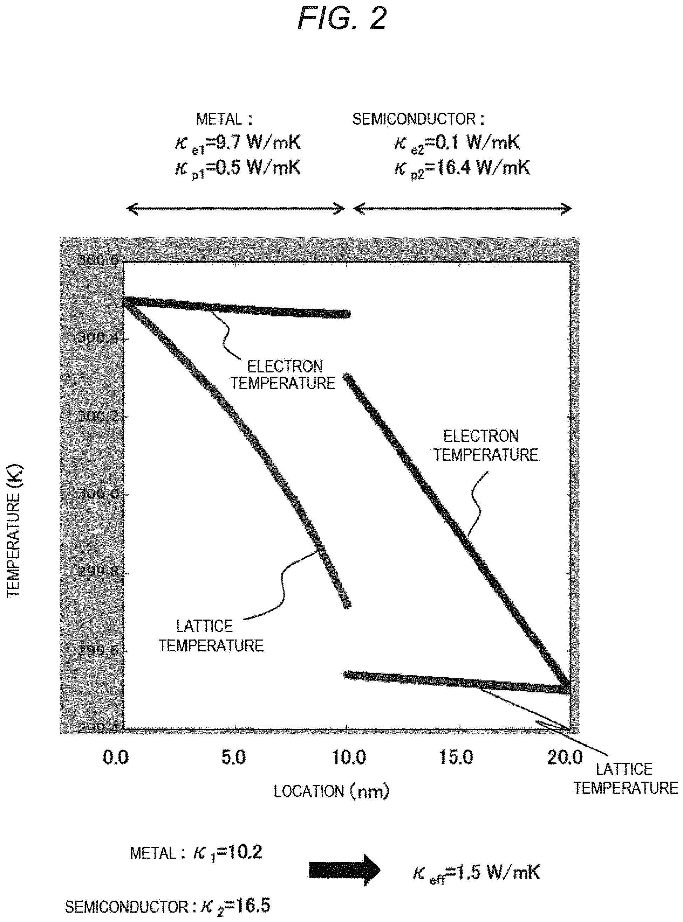

FIG. 2 represents the result of a simulation of the electron temperature and the lattice temperature in each material region of the joined unit of the metallic material and the semiconductor material shown in FIG. 1. In FIG. 2, the thermal conductivity of the metallic material is $\kappa_1$ = 10.2 W/mK ($\kappa_{e1}$ = 9.7 W/mK, $\kappa_{p1}$ = 0.5 W/mK), and the thermal conductivity of the semiconductor material is $\kappa_2$ = 16.5 W/mK ($\kappa_{e2}$ = 0.1 W/mK, $\kappa_{p2}$ = 16.4 W/mK) . The interfacial thermal resistance of electrons is $\rho_{e12}$ = 0.2 m$^2$/GW, and the interfacial thermal resistance of a lattice is $\rho_{p12}$ = 2.8 m$^2$/GW.

The result of the simulation of electron temperature and lattice temperature represented in FIG. 2 is based on the temperature difference created across the joined unit by making the temperature at the end portion of the metallic material 300.5 K, and the temperature at the end portion of the semiconductor material 299.5 K. The simulation of electron temperature and lattice temperature represented in FIG. 2 was conducted for the metallic material and the semiconductor material including two types of heat carriers: electrons and a lattice. The metallic material had a thickness $l_1$ of 10 nm, and the semiconductor material had a thickness $l_2$ of 10 nm.

It can be seen in the simulation result shown in FIG. 2 that the state of electron temperature changes, and the state of lattice temperature changes are considerably different between the metallic material region (hereinafter, referred to as "metal region") and the semiconductor material region (hereinafter, referred to as "semiconductor region"). Specifically, the lattice temperature greatly varies in the metal region while there is hardly any change in electron temperature. In the semiconductor region, the electron temperature shows large changes while the lattice temperature remains almost the same. The effective thermal conductivity was calculated by substituting the conditions corresponding to the simulation of FIG. 2 into the formulae (2) to (9). The effective thermal conductivity $\kappa_{eff}$ was 1.5 W/mK for the joined unit as a whole, about 1/10 of the thermal conductivity (16.5 W/mK) of the semiconductor material alone.

From the result shown in FIG. 2, the thermal conductivity of the joined unit as a whole can be greatly reduced in a system obtained by joining the first material and the second material, when the first material (metallic material) is a material having a lattice thermal conductivity $\kappa_{p1}$ that is lower than the electron thermal conductivity $\kappa_{e1}$, and in which electrons are the main heat carrier, and the lattice thermal conductivity $\kappa_{p1}$ is lower than the lattice thermal conductivity $\kappa_{p2}$ of the second material (semiconductor material), and the second material (semiconductor material) is a material having an electron thermal conductivity $\kappa_{e2}$ that is lower than the lattice thermal conductivity $\kappa_{p2}$, and in which the lattice is the main heat carrier. The thermal conductivity as a thermoelectric conversion device also can be reduced even when the second material is, for example, a semiconductor material having high lattice thermal conductivity, provided that it is combined with the first material satisfying the foregoing conditions.

By forming the joined unit of the metallic material and the semiconductor material as a thermoelectric conversion device, the proportion of the high-resistance semiconductor phase in the whole thermoelectric conversion device can be reduced. This improves the electrical conductivity of the joined unit as a whole, as compared to when the thermoelectric conversion device is configured solely from the semiconductor phase.

In the simulation result shown in FIG. 2, most of the temperature gradient of electrons occurs in the semiconductor region with the electron thermal conductivities and the lattice thermal conductivities ($\kappa_{e1}$, $\kappa_{p1}$, $\kappa_{e2}$, $\kappa_{p1}$) of the metallic material and the semiconductor material satisfying the foregoing relationships. In this way, the Seebeck coefficient, as a mean value of the joined unit as a whole, can maintain about 80% of the Seebeck coefficient of the semiconductor material alone, even when the Seebeck coefficient of the high-electrical-conductivity metal region is extremely low.

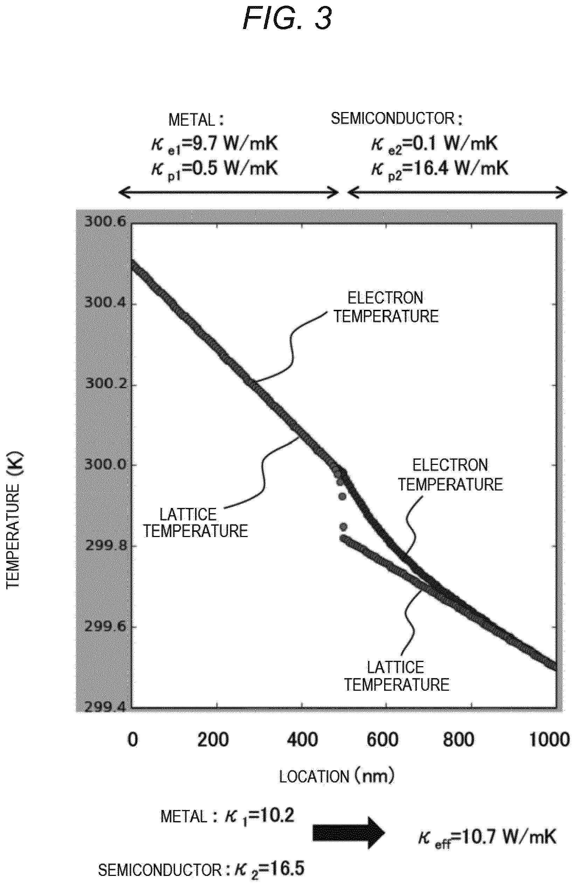

FIG. 3 represents the result of the simulation of electron temperature and lattice temperature conducted for each material region in the same manner as in FIG. 2, except that the metallic material had a thickness $l_1$ of 500 nm, and the semiconductor material had a thickness $l_2$ of 500 nm. In the temperature simulation shown in FIG. 3, the metallic material and the semiconductor material used the same materials used in FIG. 2. The difference is that these materials had a thickness of 500 nm.

As shown in FIG. 3, with a material thickness of 500 nm, changes in electron temperature and lattice temperature were almost the same in the metal region. In the semiconductor region, there was hardly any difference between the electron temperature and the lattice temperature at the end portion of the semiconductor region, though the electron temperature and the lattice temperature differed to some extent in the vicinity of the joint interface.

As demonstrated above, the result of the simulation conducted with the semiconductor material having a thick-

ness $l_1$ of 500 nm, and the metallic material having a thickness $l_2$ of 500 nm was greatly different from when these materials had a thickness of 10 nm as in FIG. 2. The effective thermal conductivity was calculated by substituting the conditions corresponding to the simulation of FIG. 3 to the formulae (2) to (9). The effective conductivity $\kappa_{eff}$ of the joined unit as a whole was 10.7 W/mK, and there was no large decrease from the thermal conductivity (16.5 W/mK) of the semiconductor material alone.

The smaller thermal conductivity decrease in the temperature simulation represented in FIG. 3 is due to the larger material thicknesses $l_1$ and $l_2$ than in FIG. 2, and the thicknesses $l_1$ and $l_2$ being sufficiently longer than the length $(d_1, d_2)$ that greatly affects the electron-lattice coupling. Accordingly, in order to obtain the effect that greatly reduces thermal conductivity with the joined first and second materials, it is desirable that the materials have thicknesses $l_1$ and $l_2$ of 500 nm or less. Specifically, the distance from the joint interface 30 between the first material and the second material to end portions of the first and the second material forming the joint interface 30 is desirably 500 nm or less each side.

In order to greatly reduce thermal conductivity by joining different materials in the manner described above, it is effective to make the value of d larger in the formula (2). As can be seen from the formula (4) defining d, the value of d can be effectively increased by making the value of electron-lattice coupling factor G smaller. By approximation, the G value can be represented by the following formula (10) (see Phys. Rev. B 77, 075133 (2008) 075133-4).

$$ G = \frac{\pi \hbar k_B \lambda \langle \omega^2 \rangle}{D(\varepsilon_F)} \int_{-\infty}^{\infty} D^2(\varepsilon) \left( -\frac{\partial f}{\partial \varepsilon} \right) d\varepsilon \qquad \cdots (10) $$

In the formula (10), $D(\varepsilon)$ represents the density of states at energy $\varepsilon$, $\varepsilon_F$ represents the Fermi energy, and $\lambda \langle \omega^2 \rangle$ represents the material parameter related to electron-lattice coupling. It can be seen in formula (10) that the G value tends to increase with materials having a higher density of states at the Fermi energy. Accordingly, increasing the d value is effective in reducing the effective thermal conductivity $\kappa_{eff}$ (i.e., in increasing the thermal resistance R). To provide a large d value, it is desirable to make the G value smaller by choosing a material having a low density of states at the Fermi energy.

Taken together, in order to reduce the effective thermal conductivity $\kappa_{eff}$ of the joined unit as a whole, it is desirable that the first material combined with the second material is a material that has a low density of states at the Fermi energy, in addition to satisfying the conditions described above with reference to FIG. 2.

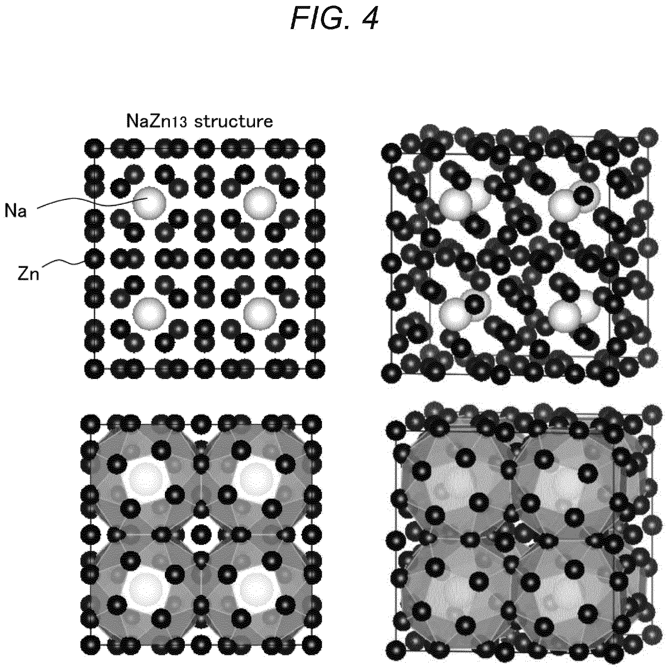

Typical examples of the first material having a small lattice thermal conductivity, and a low density of states at the Fermi energy include metallic materials having a $NaZn_{13}$-type crystalline structure. FIG. 4 shows a $NaZn_{13}$-type crystalline structure. In FIG. 4, the blank circle represents Na, and the solid circle represents Zn. As shown in FIG. 4, the $NaZn_{13}$-type crystalline structure includes the alkali metal sodium being surrounded by zinc in the form of a basket. A compound with such a basket-like crystalline structure easily lowers its lattice thermal conductivity, and is preferred for use as the metallic material. The metallic material of the $NaZn_{13}$-type crystalline structure may be one in which an alkali earth metal element occupies the Na site, and a metallic element such as Cu occupies the Zn site, for example, such as in $BaCu_{13}$.

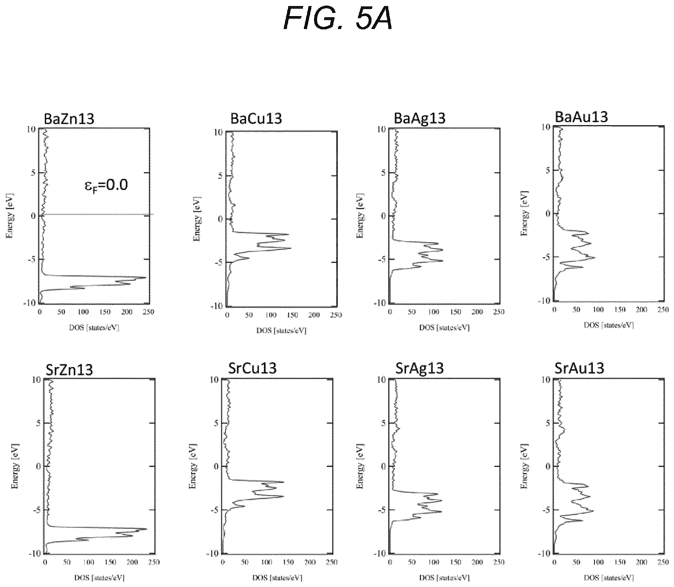

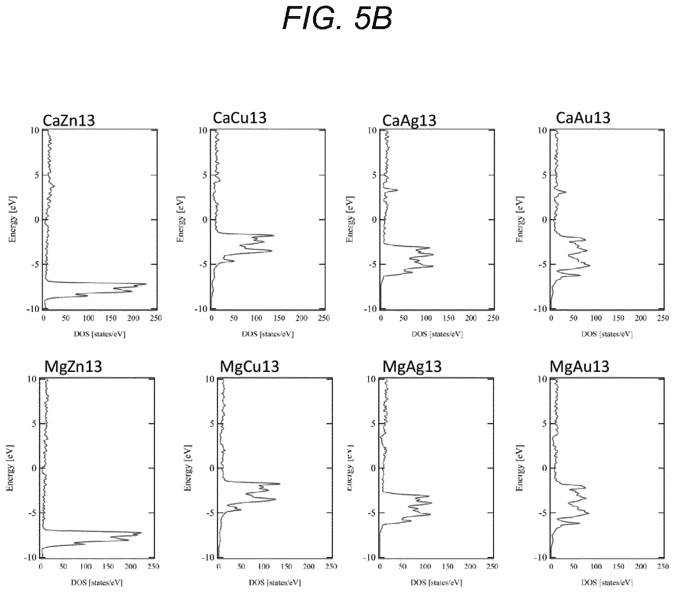

FIGS. 5A and 5B represent the relationship between density of states and energy for compounds having the $NaZn_{13}$-type crystalline structure. FIGS. 5A and 5B represent the relationship between density of states and energy for compounds in which the Na site of the $NaZn_{13}$-type crystalline structure is substituted with the alkali earth metal elements Mg, Ca, Sr, and Ba, and the Zn site is substituted with Cu, Ag, and Au.

It can be seen in FIGS. 5A and 5B that the density of states at the Fermi energy is low in all of these compounds. The compounds of the $NaZn_{13}$-type crystalline structure are not limited to the compounds shown in FIGS. 5A and 5B, and may be, for example, compounds in which the Na site is substituted with an alkali metal such as Li and K.

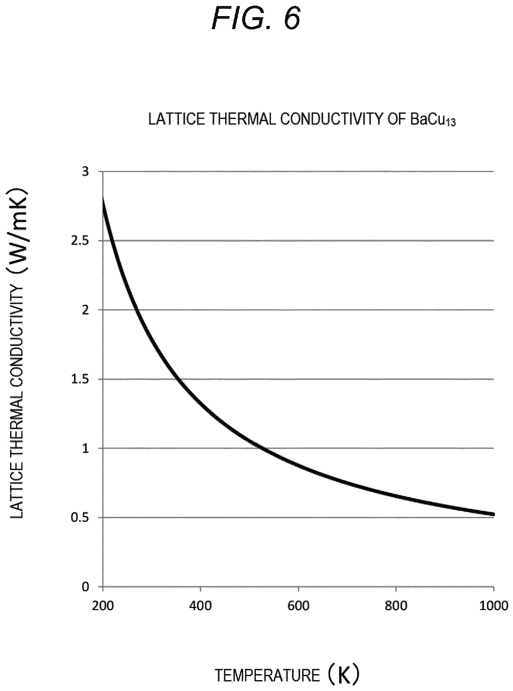

FIG. 6 represents the result of calculations of the relationship between the lattice thermal conductivity of $BaCu_{13}$ and temperature. As shown in FIG. 6, the lattice thermal conductivity of $BaCu_{13}$ is 1.8 W/mK at 300 K. This is sufficiently lower than the lattice thermal conductivity of, for example, single crystals of silicon, which is 156 W/mK at 300 K.

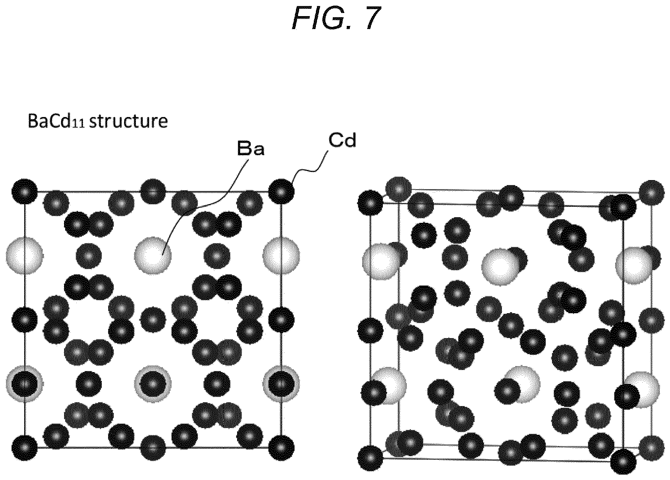

Other examples of the compounds having a low lattice thermal conductivity and a low density of states at the Fermi energy include metallic materials of the $BaCd_{11}$-type crystalline structure, the $Mg_2Zn_{11}$-type crystalline structure, the $Na_4Si_{23}$-type crystalline structure, the $CaCu_5$-type crystalline structure, and the $MgCu_2$-type crystalline structure shown in FIGS. 7 to 11.

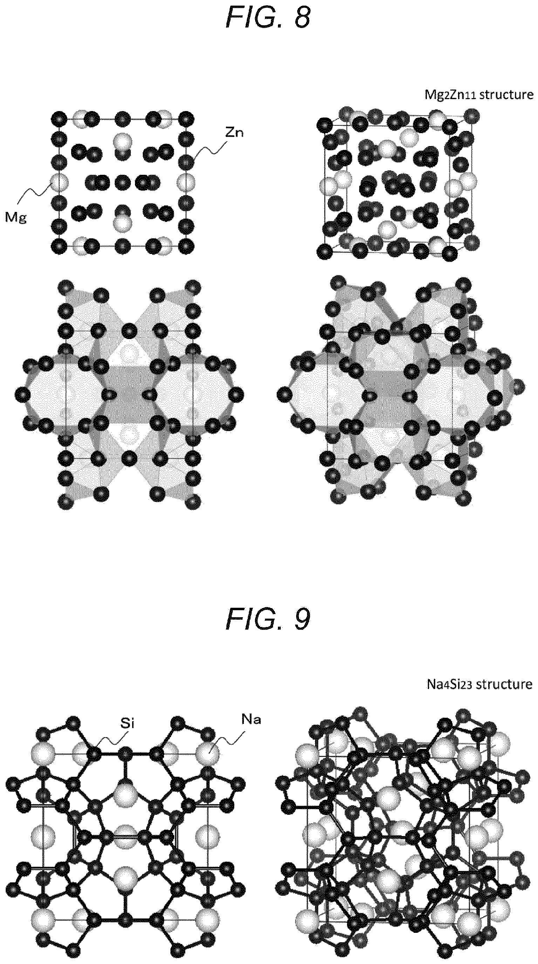

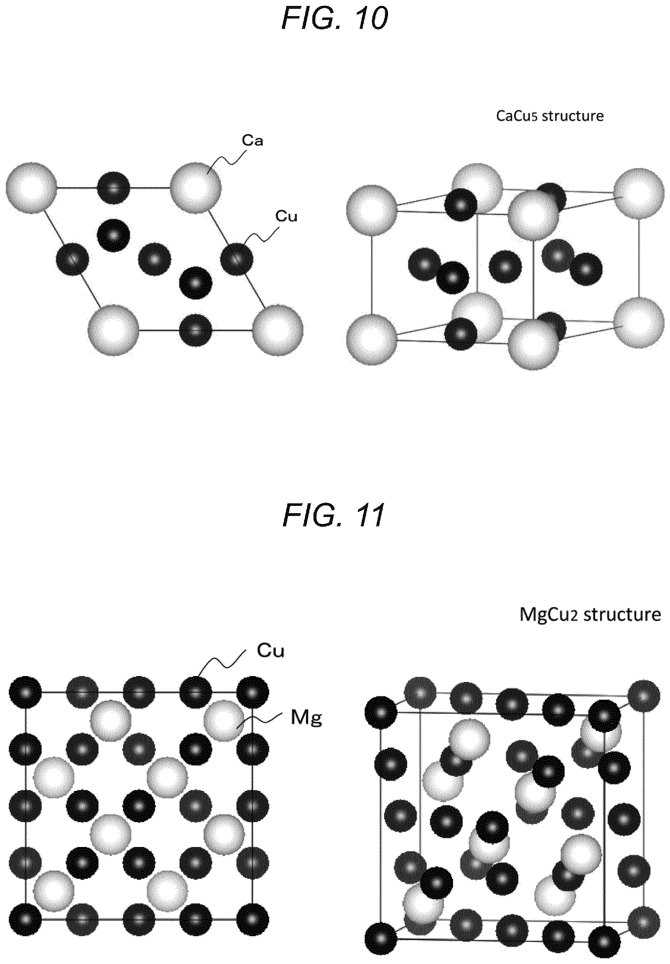

In FIG. 7, the blank circle represents Ba, and the solid circle represents Cd. In FIG. 8, the blank circle represents Mg, and the solid circle represents Zn. In FIG. 9, the blank circle represents Na, and the solid circle represents Si. In FIG. 10, the blank circle represents Ca, and the solid circle represents Cd. In FIG. 11, the blank circle represents Mg, and the solid circle represents Cu.

Examples of the first material having a low lattice thermal conductivity, and a low density of states at the Fermi energy (i.e., weak electron-lattice coupling) include compounds represented by composition formula $AB_x$. In the composition formula $AB_x$, the element A is at least one element selected from the group consisting of Li, Na, K, Rb, Cs, Mg, Ca, Sr, Ba, Sc, Y, La, Bi, He, Ne, Ar, Kr, and Xe, and the element B is at least one element selected from the group consisting of Zn, Cu, Ag, Au, Al, Ga, In, Si, Ge, and Sn. In the composition formula $AB_x$, compounds with x falling in the range $2 \leq x \leq 13$ can have the $NaZn_{13}$-type crystalline structure, the $BaCd_{11}$-type crystalline structure, the $Mg_2Zn_{11}$-type crystalline structure, the $Na_4Si_{23}$-type crystalline structure, the $CaCu_5$-type crystalline structure, the $BaZn_5$-type crystalline structure, or the $MgCu_2$-type crystalline structure mentioned above.

The elements exemplified for the element B in composition formula $AB_x$ all have a lower density of states at the Fermi energy than, for example, transition metal elements such as Fe, Pt, Pd, and Rh, and compounds containing primarily these elements have weak electron-lattice coupling G.

That is, compounds represented by composition formula $AB_x$ and having any of the crystalline structures described above have low lattice thermal conductivity, and weak electron-lattice coupling.

When the element B of composition formula $AB_x$ is primarily an element selected from the foregoing elements excluding Si, Ge, and Sn, the compounds represented by composition formula $AB_x$ have metallic properties. When the proportions of Si, Ge, and Sn in the element B are increased, the compounds represented by composition formula $AB_x$ have semimetallic properties with a reduced carrier density. The electrical conductivity can be adjusted in this fashion by appropriately selecting the elements of composition formula $AB_x$.

There is also a cost advantage in choosing Cu or Zn as the element B in composition formula $AB_x$ because these elements, aside from being commonly available, make it easier to provide a low density of states at the Fermi energy.

When the element B in composition formula $AB_x$ is Al, Ga, or In, stronger electron-lattice coupling G tends to occur than when Cu or Zn is used. From the viewpoint of reducing electron-lattice coupling G, it is accordingly preferable to increase the proportions of, for example, Zn, Cu, Ag, and Au in element B.

The element A may be a noble gas element such as He, Ne, Ar, Kr, and Xe, as mentioned above. Adding such noble gas elements is effective at reducing lattice thermal conductivity, and noble gas elements may be added to the base component of the first material using techniques such as ion doping. From a cost reduction standpoint, preferred as element A is La or Ba.

In the thermoelectric conversion device according to the embodiment, the second material used is a thermoelectric conversion material having an electron thermal conductivity that is lower than the lattice thermal conductivity, and having a higher Seebeck coefficient than the first material (i.e., a higher power factor). The second material may be a p-type thermoelectric conversion material, or an n-type thermoelectric conversion material, provided that it satisfies the foregoing conditions.

Examples of the second material include Group IV semiconductor materials of primarily Si or Ge, which are inexpensive, and have good compatibility with a semiconductor device. Compounds containing Group IV elements such as Si are commonly available as semiconductor material, and can preferably be used as the second material because of their environmental friendliness and low cost. Also preferred depending on the application are silicides - compounds containing silicon and metallic elements, and germinides - compounds containing germanium and metallic elements, because these compounds are also desirably compatible with a semiconductor device.

Other preferred examples of materials used as the second material include compounds containing transition metal elements. Specifically, the thermal electromotive force of a material as the thermoelectric conversion material is strongly dependent on the electron state of the material, and, in order to obtain a high thermal electromotive force, it is preferable to use materials that show steep density of states changes in the vicinity of the Fermi level. A localized electron state is required to provide a large density of states change. In order to obtain a large thermal electromotive force, it is accordingly preferable to use a material system, for example, such as transition metal elements, in which the d orbital electrons contribute to the electron state in the vicinity of the Fermi level.

Examples of relatively inexpensive transition metal elements include iron (Fe) and manganese (Mn). For example, a material system containing a matrix compound in which the electron state derived from the 3d orbital of iron occurs in the vicinity of the Fermi level is a preferred thermoelectric conversion material because it is abundant in the crust, and is available at low cost, in addition to being environmentally friendly.

From the viewpoint of obtaining a large thermal electromotive force, it is accordingly preferable to use, for example, silicide semiconductor fine particles, such as $Mn_4Si_7$ and $\beta$-$FeSi_2$, as the second material. The compound containing transition metal elements may be, for example, $MoSi_2$, $TiSi_2$, $TiGe_2$, $ZrSn_2$, $V_{17}Ge_{31}$, $Cr_{11}Ge_{19}$, $Mo_9Ge_{16}$, $Mo_{13}Ge_{23}$, $Ru_2Ge_3$, $Ru_2Si_3$, $Os_2Ge_3$, $Os_2Si_3$, $Rh_{17}Ge_{22}$, $Mn_4Si_7$, $Re_4Ge_7$, $Mn_{11}Si_{19}$, $Mn_{15}Si_{26}$, $Mn_{27}Si_{47}$, $Mn_{26}Si_{45}$, $Mn_7Si_{12}$, $Mn_{19}Si_{33}$, $Mn_{39}Si_{68}$, $Ir_4Ge_5$, or $Co_2Si_3$. These compounds may be used alone as the second material, or the compounds containing transition metal elements may be used with materials that are primarily Si or Ge.

The second material also may be a compound having a pyrite structure, for example, such as $FeS_2$, $AuSb_2$, $CaC_2$, $CoS_2$, $MnS_2$, $NiS_2$, $NiSe_2$, $OSS_2$, $OsTe_2$, $PdAs_2$, $PtAs_2$, $PtBi_2$, $RhSe_2$, and $RuS_2$, or an oxide semiconductor or a sulfide semiconductor. It is also possible to use, for example, a full-Heusler alloy, a half-Heusler alloy, a clathrate material, or skutterudite. The full-Heusler alloy may be, for example, $Fe_2VAl$ or $Fe_2TiSi$. The half-Heusler alloy may be, for example, FeNbSb. The clathrate material may be, for example BaGaSn. The skutterudite may be, for example, $CoSb_3$. These materials cannot be produced on a semiconductor device, for example, such as a silicon semiconductor device, as easily as the compounds containing Group IV elements. Nevertheless, these materials may be appropriately selected according to the subject to which the thermoelectric conversion material is applied.

The second material may be a material doped with the desired element, using the foregoing compounds as the base material. The first material may be, for example, an organic semiconductor.

The thermoelectric conversion device according to the embodiment may be configured as a joined unit of the first material and the second material that are appropriately selected from the foregoing materials so that the lattice thermal conductivity of the first material is lower than the lattice thermal conductivity of the second material, and that the Seebeck coefficient of the second material is higher than the Seebeck coefficient of the first material.

With the thermoelectric conversion device according to the embodiment described above, the thermoelectric conversion performance can be greatly improved by joining the first material and the second material, as compared to the thermoelectric conversion device configured from the same material. As described above, the first material is a high-electrical-conductivity material having a lattice thermal conductivity that is lower than its electron thermal conductivity, and in which the lattice thermal conductivity is lower than the lattice thermal conductivity of the second material, and the electron-lattice coupling is weak. The second material is a material having a higher Seebeck coefficient than the first material, and a high power factor ($\sigma S2$), as described above.

When the distance from the joint interface between the first material and the second material to end portions of the first material and the second material forming the joint interface is 500 nm or less each side, the thermal conductivity can be greatly reduced as compared with a thermoelectric conversion device configured from the same material, and the electrical conductivity of the joined unit improves as a whole. It is therefore possible to provide low thermal conductivity and high electrical conductivity and high Seebeck coefficient in the joined unit as a whole, and the thermoelectric conversion performance can greatly improve, even when, for example, a material having high lattice thermal conductivity is used as the second material.

It is also possible to greatly reduce cost when the first or second material is an inexpensive abundant material, as compared to when, for example, Bi-Te-based materials are used.

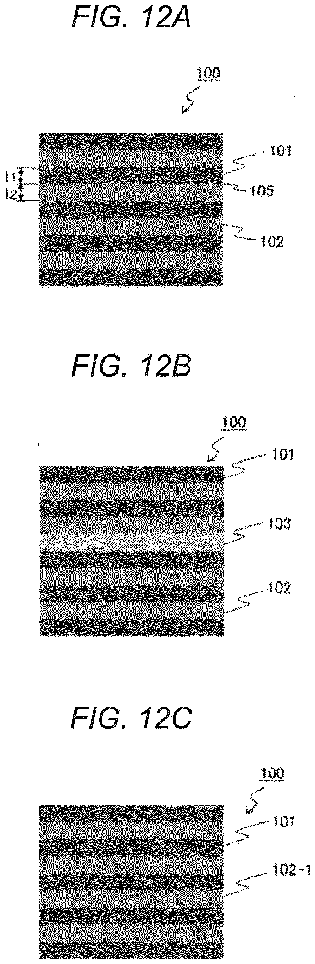

A specific exemplary structure of a thermoelectric conversion device produced with the first material and the second material above is described below with reference to FIGS . 12A to 13B. A thermoelectric conversion device 100 shown in FIG. 12A has a periodic multilayer structure in which the first and the second material that differ with respect to the primary component of the heat carrier are alternately laminated in layers. Specifically, the thermoelectric conversion device 100 is configured so that a first layer 101 formed of the first material, and a second layer 102 formed of the second material are alternately laminated. The first layer 101 and the second layer 102 are joined to each other at a joint interface 105. The distance $l_1$ from the joint interface 105 to an end portion of the first layer 101 (i.e., the thickness $l_1$ of the first layer 101), and the distance $l_2$ from the joint interface 105 to an end portion of the second layer 102 (i.e., the thickness $l_2$ of the second layer 102) are 500 nm or less. In this way, the thermoelectric conversion device shown in FIGS. 12A to 12C can have an effect that unidirectionally reduces thermal conductivity in the laminate direction of the first layer 101 and the second layer 102.

The thermoelectric conversion device of the multilayer structure may be structured so that a layer 103 of a material different from the first material and the second material is interposed between the first layer 101 and the second layer 102, for example, as shown in FIG. 12B.

In many cases, the thermoelectric conversion device requires both a p-type thermoelectric conversion device, and an n-type thermoelectric conversion device. It is accordingly possible, as shown in FIG. 12C, to form a second layer 102-1 by selecting a common p- or n-type thermoelectric conversion material as the second material satisfying the foregoing conditions, and form the first layer 101 by using a material selected as the first material satisfying the foregoing conditions, specifically, a material having low lattice thermal conductivity, and weak electron-lattice coupling. A thermoelectric conversion device with appropriately selected p-type performance or n-type performance can thus be obtained by laminating the second layer 102-1 and the first layer 101 in the manner shown in FIG.12C.

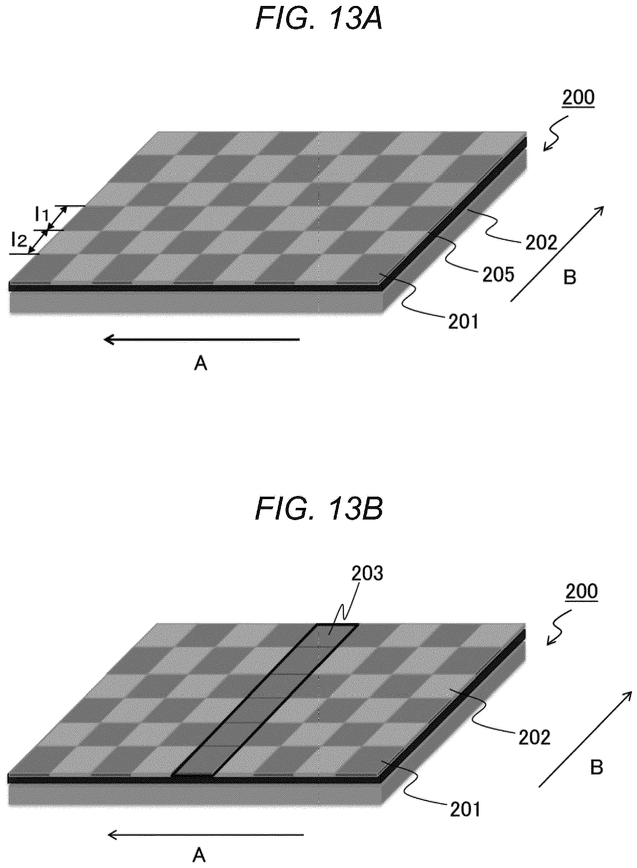

A thermoelectric conversion device 200 may have a two-dimensional lattice structure in which a first lattice 201 formed of the first material, and a second lattice 202 formed of the second material are alternately arranged on the same plane as shown in FIG. 13A. As illustrated in FIG. 13B, a waveguide structure 203 may be formed in a part of the lattice structure shown in FIG. 13A.

The first lattice 201 and the second lattice 202 are joined to each other at a joint interface 205. The distance $l_1$ from the joint interface 205 to an end portion of the first lattice 201 (i.e., the width of the first lattice 201), and the distance $l_2$ from the joint interface 205 to an end portion of the second lattice 202 (i.e., the width of the second layer 102) are 500 nm or less. The distance $l_1$, $l_2$ is the longest distance from the joint interface 205 to an end portion of each material.

In the thermoelectric conversion device shown in FIGS. 13A and 13B, reduction of thermal conductivity occurs in directions joining the first lattice 201 and the second lattice 202, that is, the directions indicated by arrows A and B. In this way, the effect that lowers thermal conductivity can occur in a two-dimensional fashion.

In the examples shown in FIGS. 13A and 13B, the lattices 201 and 202 are structured as square lattices. However, for example, the two-dimensional periodic structure may be formed by forming triangular lattices, or a two-dimensional lattice structure may be formed by forming a honeycomb structure with hexagonal lattices. A defect structure may be formed in a part of the two-dimensional lattice structure shown in FIGS. 13A and 13B to increase thermal conductivity in only a part of the plane. This makes it possible to more freely design the device structure.

Though not illustrated, the thermoelectric conversion device 200 shown in FIG. 13A or 13B may be laminated to produce a thermoelectric conversion device in which the first lattice 201 and the second lattice 202 are three-dimensionally joined. Specifically, for example, the thermoelectric conversion device 200 is laminated on another thermoelectric conversion device 200 so that the second lattice 202 is disposed on the first lattice 201 of the thermoelectric conversion device 200 shown in FIG. 13A, and the first lattice 201 is disposed on the second lattice 202 of the thermoelectric conversion device 200. In the thermoelectric conversion device produced in this manner, reduction of thermal conductivity occurs in a three-dimensional fashion in directions joining the first lattice 201 and the second lattice 202. That is, the effect that lowers thermal conductivity occurs in a direction orthogonal to the principal surface of the thermoelectric conversion device 200, in addition to the directions indicated by arrows A and B in FIGS. 13A and 13B.

In the thermoelectric conversion device shown in FIGS. 12A to 13B, the first material and/or the second material may be configured from nanoparticles. Specifically, the first layer 101 and/or the second layer 102 shown in FIGS. 12A to 12C may be configured from nanoparticles, and the first lattice 201 and/or the second lattice 202 shown in FIGS. 13A and 13B may be configured from nanoparticles.

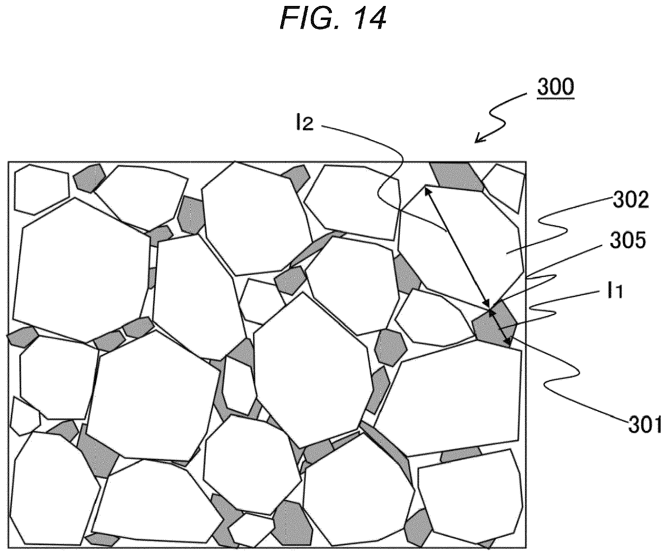

It is also possible to form the thermoelectric conversion device as a nanoparticle complex 300, which is a mixture of first nanoparticles 301 constituting the first material, and second nanoparticles 302 constituting the second material, as shown in FIG. 14. In the nanoparticle complex 300, as shown in FIG. 14, the first nanoparticles 301 and the second nanoparticles 302 occur as a mixture by contacting each other at an interface 305.

The first nanoparticles 301 and the second nanoparticles 302 are in contact with each other at the interface 305. The distance $l_1$ from the interface 305 to an end portion of the first nanoparticles 301, and the distance $l_2$ from the interface 305 to an end portion of the second nanoparticles 302 are 500 nm or less. The distance $l_1$, $l_2$ is the longest distance from the interface 305 to an end of each particle.

By mixing the nano-sized particles of the materials in the manner shown in FIG. 14, the interface between the particles increases, and the thermal conductivity can be greatly reduced by phonon scattering. The particles maybe configured so that, for example, the first nanoparticles and the second nanoparticles contact each other by self-assembly.

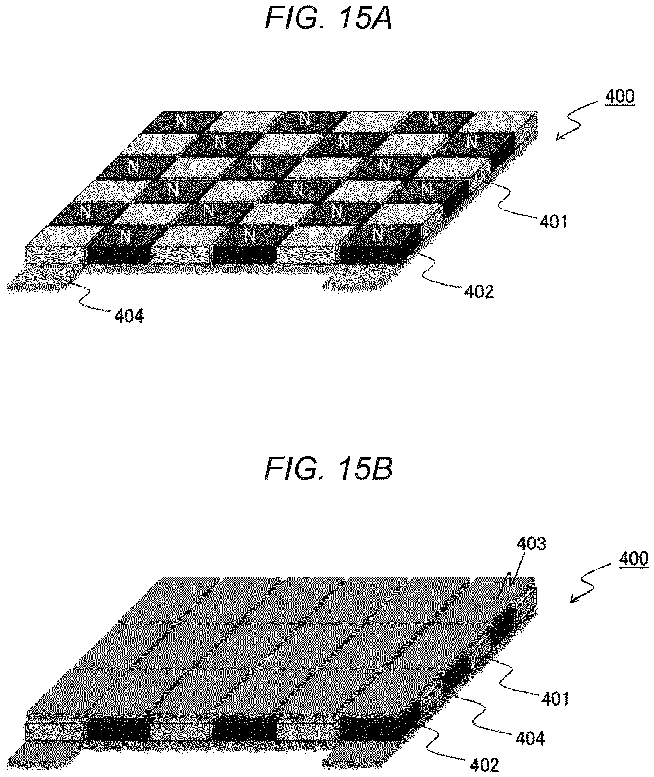

FIGS. 15A and 15B show a thermoelectric conversion module 400 produced by using the thermoelectric conversion device shown in FIGS. 12A to 12C, or FIGS. 13A and 13B. FIG. 15A is a perspective view showing the whole configuration of the thermoelectric conversion module after the upper electrode shown in FIG. 15B has been removed. In FIGS. 15A and 15B, the thermoelectric conversion module 400 is configured so that a p-type thermoelectric conversion device 401, and an n-type thermoelectric conversion device 402 are alternately disposed.

The p-type thermoelectric conversion device 401 shown in FIGS. 15A and 15B may use, for example, the thermoelectric conversion device 100 including the second layer 102 formed of a p-type thermoelectric conversion material shown in FIG. 12C, or the thermoelectric conversion device 200 including the second lattice 202 formed of a p-type thermoelectric conversion material shown in FIG. 13A. The n-type thermoelectric conversion device 402 may be formed in the same manner as for the p-type thermoelectric conversion device 401, except that an n-type thermoelectric conversion material is used.

In the thermoelectric conversion module 400, the p-type thermoelectric conversion device 401 and the n-type thermoelectric conversion device 402 are connected to each other in pairs by an upper electrode 403 (see FIG. 15B) that is provided in contact with the principal surfaces (the upper surfaces in FIG. 15A) of the p-type thermoelectric conversion device 401 and the n-type thermoelectric conversion device 402, and the resulting π-type structures are arranged on the same plane to form the thermoelectric conversion module 400. In the thermoelectric conversion module 400 shown in FIG. 15B, the p-type thermoelectric conversion device 401, and the n-type thermoelectric conversion device 402 that is not connected to the p-type thermoelectric conversion device 401 with the upper electrode 403 are connected to a lower electrode 404.

The thermoelectric conversion module 400 shown in FIGS. 15A and 15B are configured so that, for example, when the upper electrode 403 side is the high-temperature side, and the lower electrode 404 side is the low-temperature side, current travels in a direction from the low-temperature side to the high-temperature side in the n-type thermoelectric conversion device 402, and from the high-temperature side to the low-temperature side in the p-type thermoelectric conversion device 401.

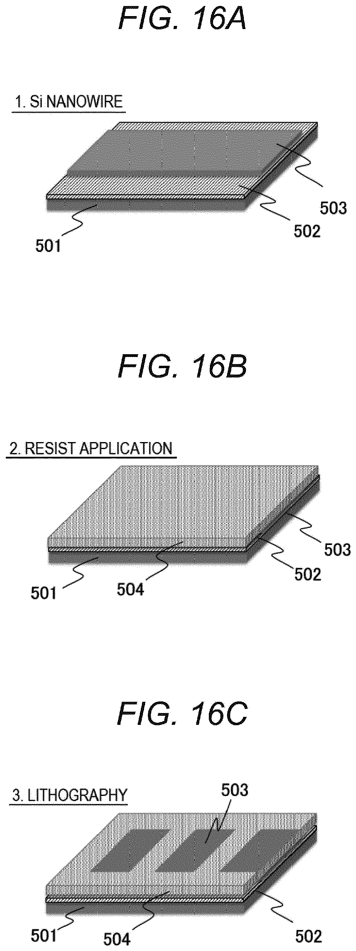

A method for producing the thermoelectric conversion device described above is described below with reference to FIGS. 16A to 16E. FIGS. 16A to 16E describe a method in which the first lattice and the second lattice are alternately arranged and joined on the same plane to form a nanowire-type thermoelectric conversion device 500 (hereinafter, referred to as "thermoelectric conversion nanowire 500) using a lithography process.

As shown in FIG. 16A, a SOI substrate is prepared by forming a Si nanowire 503 on a Si substrate 501 via a $SiO_2$ film 502 (step 1). Thereafter, as shown in FIG. 16B, a lithography resist is applied to the SOI substrate, for example, by spin coating, to form a resist film 504 (step 2), and the resist film 504 is patterned into the shape shown in FIG. 16C by, for example, exposure and development using a mask (step 3).

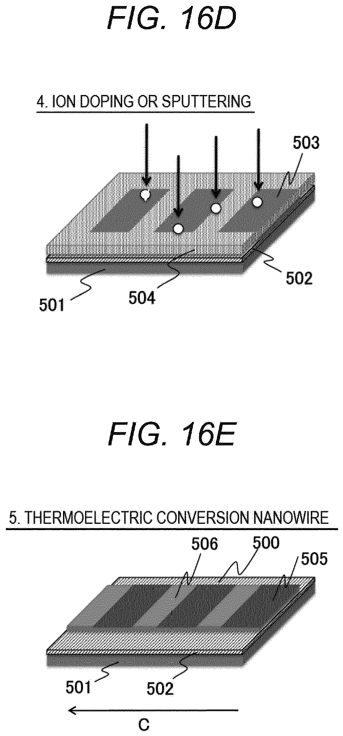

Thereafter, as shown in FIG. 16D, the first material is ion doped or sputtered in the patterned region formed in the resist film 504 (step 4) to form a first lattice 505. When sputtering is performed in step 4, for example, the patterning is followed by post-baking, and the whole is dipped in an acidic or alkaline solution to remove the Si nanowire 503 in the patterned region. The region after the removal of the Si nanowire 503 is sputtered. Thereafter, as shown in FIG. 16E, the resist film 504 is removed with a solvent to obtain the thermoelectric conversion nanowire 500 in which the first lattice 505 and the second lattice 506 are alternately arranged on the same plane (step 5).

The thermoelectric conversion nanowire 500 obtained by using the method described above can exhibit the effect that unidirectionally lowers thermal conductivity in the direction of arrow C in FIG. 16E, and provide desirable electrical conductivity.

The production of the thermoelectric conversion device according to the embodiment is not limited to the lithography described above, and the thermoelectric conversion device may be produced using other techniques, including, for example, sputtering, vacuum vapor deposition, and CVD. The first material or the second material may be formed into nano-sized fine particles by, for example, mechanical alloying, or the particles may be allowed to undergo self-assembly to form the material joint interface.

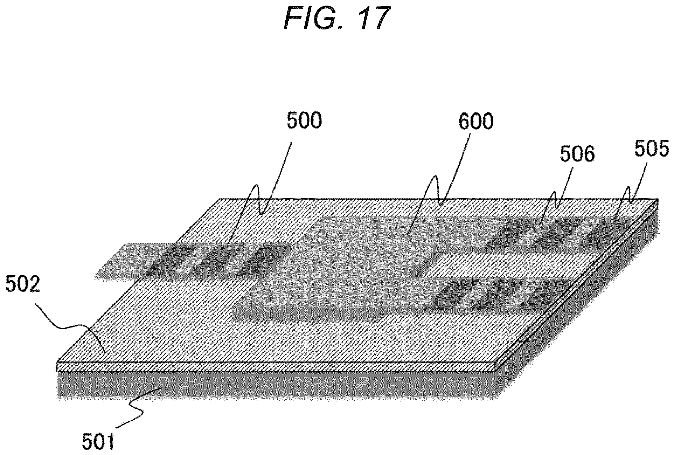

The thermoelectric conversion nanowire 500 produced in the manner described above may be configured so that, for example, as shown in FIG. 17, the thermoelectric conversion nanowire 500 is electrically connected to the adiabatic region 600 of a low-thermal-conductivity material on the Si substrate 501 having the $SiO_2$ film 502.

In the configuration shown in FIG. 17, the thermoelectric conversion nanowires 500 can produce the Seebeck effect when a temperature difference is created between the adiabatic region 600 and the terminal of each thermoelectric conversion nanowire 500 by, for example, increasing the temperature of the adiabatic region 600, and decreasing the temperature at the terminal of the thermoelectric conversion nanowire 500. The Peltier effect can be obtained by applying voltage to the thermoelectric conversion nanowire 500. This allows for temperature control on the Si substrate 501.

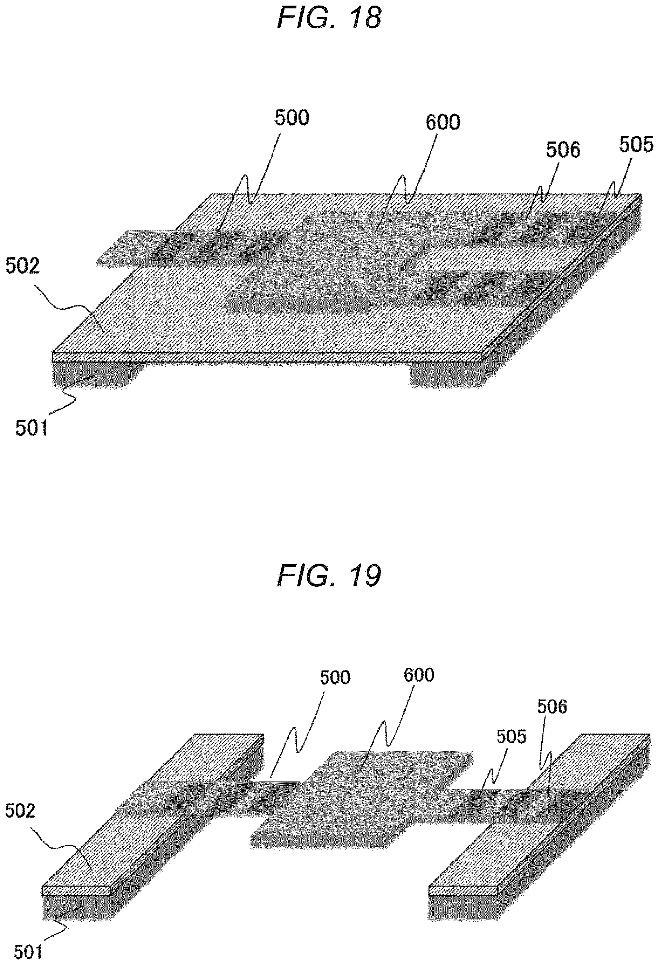

From the viewpoint of improving the adiabatic property of the adiabatic region 600 in FIG. 17, it is possible to adopt a configuration in which, for example, as shown in FIG. 18, the Si substrate 501 is removed from the region directly below and in the vicinity of the adiabatic region 600, or a configuration in which, for example, as shown in FIG. 19, the Si substrate 501 and the $SiO_2$ film 502 are removed from the region directly below and in the vicinity of the adiabatic region 600.

The thermoelectric conversion device according to the embodiment can be used in relatively low temperature regions, for example, 200°C or less. For example, the thermoelectric conversion device according to the embodiment can be used to efficiently collect relatively low exhaust heat, for example, the exhaust heat from subways and substations, which is typically in a low temperature range of 40 to 80°C.

The continuously improving performance of computers has increased the amount of heat generated in a computer circuit, and there is a need for cooling the computer circuit to prevent a performance drop of a computer due to generated heat. Such demands extend beyond the computer circuit. For example, there is a potential need for cooling power device units such as in inverters of electrical appliances. The thermoelectric conversion device according to the embodiment can have high thermoelectric conversion performance in the vicinity of room temperature in applications such as in cooling of a computer. This makes it possible to efficiently collect and reuse the relatively low exhaust heat from computers and electrical appliances.

The thermoelectric conversion device according to the embodiment also can be used to efficiently collect relatively high exhaust heat, for example, the high exhaust heat of 300 to 600°C from an incinerator plant.

The thermoelectric conversion device enables heat control both locally and easily, and, for example, a circuit device including both a heater unit, and a unit that is operable only in low temperature can be operated without providing a large-scale cooling device, provided that the heat of the device is controllable such as by cooling.

A semiconductor material containing Group IV elements such as silicon is preferred for cooling of a semiconductor device constituting, for example, a computer circuit.

The crystalline structure of the thermoelectric conversion material portion can be easily confirmed by X-ray diffraction (XRD). A monocrystalline or polycrystalline crystalline structure can be confirmed by observing a lattice image using an electron microscope such as a TEM (Transmission Electron Microscope), or by observing a spot pattern or a ring pattern in an electron diffraction image. The distribution of a sample composition can be confirmed by using various techniques, including EPMA (Electron Probe MicroAnalyser) such as EDX (Energy Dispersive X-ray spectroscopy), SIMS (Secondary Ionization Mass Spectrometer), X-ray photoemission spectroscopy, and ICP (Inductively Coupled Plasma). Information regarding the density of states of the material can be confirmed using techniques such as ultraviolet photoemission spectroscopy, and X-ray photoemission spectroscopy. The electrical conductivity, and the carrier density can be confirmed by 4-sensing electrical measurement, and by measuring the Hall effect. The Seebeck coefficient can be measured by measuring the voltage difference across the ends of a sample having a temperature difference. The thermal conductivity can be confirmed using the laser flash method. The lattice arrangement of the thermoelectric conversion device, and the structures including the laminate structure, and the nanoparticle complex structure can be confirmed by SEM (Scanning Electron Microscopy) or TEM with ease.

Examples of Sample Production

Examples of the production of the thermoelectric conversion device according to the embodiment are described below. The examples below are intended to illustrate the production of the thermoelectric conversion device, and the production of the thermoelectric conversion device is not limited to the conditions described below.

Production Example 1

A $BaCu_{13}$ target was sputtered on a SOI substrate having an about 20 nm-thick Si monocrystalline layer to form a Ba:Cu = 1:13 film in a thickness of about 20 nm, and a thermoelectric conversion device having a laminated $BaCu_{13}$/Si bilayer structure of a Si monocrystalline layer and a $BaCu_{13}$ crystal layer was obtained.

Production Example 2

A $BaCu_{12}Au$ target was sputtered on a SOI substrate having an about 20 nm-thick Si monocrystalline layer to form a Ba:Cu:Au = 1:12:1 film in a thickness of about 20 nm, and a thermoelectric conversion device having a laminated $BaCu_{12}Au$/Si bilayer structure of a Si monocrystalline layer and a $BaCu_{12}Au$ layer was obtained.

Production Example 3

A $Au_2Bi$ target was sputtered on a SOI substrate having an about 20 nm-thick Si monocrystalline layer to form a Au:Bi = 2:1 film in a thickness of about 20 nm, and a thermoelectric conversion device having a laminated $Au_2Bi$/Si bilayer structure of a Si monocrystalline layer and a $Au_2Bi$ layer was obtained.

Production Example 4

An N-type $Fe_2VAl$ target, and a $Au_2Bi$ target were alternately sputtered on a thermally-oxidized film-attached Si substrate in a thickness of 20 nm each, and a thermoelectric conversion device having an alternately laminated $Au_2Bi$/$Fe_2VAl$ multilayer structure of a Heusler alloy $Fe_2VAl$ layer and a $Au_2Bi$ layer was obtained.

Production Example 5

A $MnSi_{1.7}$ target and a $Au_2Bi$ target were alternately sputtered on a thermally-oxidized film-attached Si substrate in a thickness of 20 nm each, and a thermoelectric conversion device having an alternately laminated $Au_2Bi$/$MnSi_{1.7}$ multilayer structure of a $MnSi_{1.7}$ layer and a $Au_2Bi$ layer was obtained.

Production Example 6

A positive-type resist film for electron lithography was formed by being spin coated on a SOI substrate having an about 20 nm-thick Si monocrystalline layer (see FIG. 16A), as shown in FIG. 16B, and the resist film was patterned into a two-dimensional lattice structure (see FIG. 16C). This was followed by post-baking at 150°C. After being immersed in about 5% HF, the film was rinsed with purified water. The whole was then dipped in a 1 mol/l potassium hydroxide aqueous solution for about 2 minutes to remove the silicon in the patterned portion. This was followed by sputtering of a $BaCu_{13}$ target in the Si removed region, and an about 20 nm-thick Ba:Cu = 1:13 film was formed. An artificial $BaCu_{13}$/Si lattice structure of a two-dimensional lattice structure was obtained upon removing the resist film.

**Claims**

1. A thermoelectric conversion device comprising:

a first material represented by composition formula $AB_x$ (wherein A is at least one element selected from the group consisting of Li, Na, K, Rb, Cs, Mg, Ca, Sr, Ba, Sc, Y, La, Bi, He, Ne, Ar, Kr, and Xe, and B is at least one element selected from the group consisting of Zn, Cu, Ag, Au, Al, Ga, In, Si, Ge, and Sn), and having a lattice thermal conductivity that is lower than its electron thermal conductivity; and

a second material having a higher Seebeck coefficient than the first material, and an electron thermal conductivity that is lower than its lattice thermal conductivity,

wherein the lattice thermal conductivity of the first material is lower than the lattice thermal conductivity of the second material, and

wherein the distance from the interface between the first material and the second material to an end portion of the first material and to an end portion of the second material is 500 nm or less.

2. The thermoelectric conversion device according to claim 1, wherein x in the composition formula $AB_x$ falls in a range of $2 \leq x \leq 13$.

3. The thermoelectric conversion device according to claim 1, wherein the first material has a $NaZn_{13}$-type crystalline structure, a $BaCd_{11}$-type crystalline structure, a $Mg_2Zn_{11}$-type crystalline structure, a $Na_4Si_{23}$-type crystalline structure, a $CaCu_5$-type crystalline structure, a $BaZn_5$-type crystalline structure, or a $MgCu_2$-type crystalline structure.

4. The thermoelectric conversion device according to claim 1, wherein the first material represented by the composition formula $AB_x$ contains La or Ba as a main component of the element A, and Zn or Cu as a main component of the element B.

5. The thermoelectric conversion device according to claim 1, wherein the second material is a semiconductor material containing silicon as a main component, or a Heusler alloy containing silicon as a main component.

6. The thermoelectric conversion device according to claim 1, which has a multilayer structure in which a first layer formed of the first material, and a second layer formed of the second material are alternately laminated and joined to each other.

7. The thermoelectric conversion device according to claim 1, which has a lattice structure in which the first material and the second material are alternately arranged on the same plane, and joined to each other.

8. The thermoelectric conversion device according to claim 1, wherein at least one of the first material and the second material is configured from a nanoparticle.

9. The thermoelectric conversion device according to claim 8, which is configured as a nanoparticle complex in which a first nanoparticle constituting the first material, and a second nanoparticle constituting the second material are mixed and joined to each other.

10. A thermoelectric conversion module comprising a plurality of thermoelectric conversion devices, and an electrode electrically connecting between the thermoelectric conversion devices, wherein the plurality of thermoelectric conversion devices each represent the thermoelectric conversion device of claim 1.

**Patentansprüche**

1. Thermoelektrische Wandlervorrichtung, umfassend:

ein erstes Material, das durch die Zusammensetzungsformel ABx dargestellt wird (wobei A mindestens ein Element ist, das aus der Gruppe ausgewählt ist, die aus Li, Na, K, Rb, Cs, Mg, Ca, Sr, Ba, Sc, Y, La, Bi, He, Ne, Ar, Kr und Xe besteht, und B mindestens ein Element ist, das aus der Gruppe ausgewählt ist, die aus Zn, Cu, Ag, Au, Al, Ga, In, Si, Ge und Sn besteht), und das eine Gitter-Wärmeleitfähigkeit hat, die niedriger als seine Elektronen-Wärmeleitfähigkeit ist; und

ein zweites Material mit einem höheren Seebeck-Koeffizienten als das erste Material und einer Elektronen-Wärmeleitfähigkeit, die niedriger als seine Gitter-Wärmeleitfähigkeit ist,

wobei die Gitter-Wärmeleitfähigkeit des ersten Materials niedriger ist als die Gitter-Wärmeleitfähigkeit des zweiten Materials, und

wobei der Abstand von der Grenzfläche zwischen dem ersten Material und dem zweiten Material zu einem Endabschnitt des ersten Materials und zu einem Endabschnitt des zweiten Materials 500 nm oder weniger beträgt.

2. Thermoelektrische Wandlervorrichtung nach Anspruch 1, wobei x in der Zusammensetzungsformel ABx in einen Bereich von $2 \leq x \leq 13$ fällt.

3. Thermoelektrische Wandlervorrichtung nach Anspruch 1, wobei das erste Material eine kristalline Struktur vom $NaZn_{13}$-Typ, eine kristalline Struktur vom $BaCd_{11}$-Typ, eine kristalline Struktur vom $Mg_2Zn_{11}$-Typ, eine kristalline Struktur vom $Na_4Si_{23}$-Typ, eine kristalline Struktur vom CaCus-Typ, eine kristalline Struktur vom BaZns-Typ oder eine kristalline Struktur vom $MgCu_2$-Typ aufweist.

4. Thermoelektrische Wandlervorrichtung nach Anspruch 1, wobei das erste Material, das durch die Zusammensetzungsformel ABx dargestellt wird, La oder Ba als eine Hauptkomponente des Elements A und Zn oder Cu als eine Hauptkomponente des Elements B enthält.

5. Thermoelektrische Wandlervorrichtung nach Anspruch 1, wobei das zweite Material ein Halbleitermaterial ist, das Silizium als eine Hauptkomponente enthält, oder eine Heusler-Legierung, die Silizium als eine Hauptkomponente enthält.

6. Thermoelektrische Wandlervorrichtung nach Anspruch 1, die eine mehrschichtige Struktur aufweist, bei der eine erste Schicht aus dem ersten Material und eine zweite Schicht aus dem zweiten Material abwechselnd laminiert und miteinander verbunden sind.

7. Thermoelektrische Wandlervorrichtung nach Anspruch 1, die eine Gitterstruktur aufweist, bei der das erste Material und das zweite Material abwechselnd in derselben Ebene angeordnet und miteinander verbunden sind.

8. Thermoelektrische Wandlervorrichtung nach Anspruch 1, wobei mindestens eines des ersten Materials und des zweiten Materials aus Nanopartikeln aufgebaut ist.

9. Die thermoelektrische Wandlervorrichtung nach Anspruch 8, die als Nanopartikelkomplex konfiguriert ist, in dem ein erstes Nanopartikel, das das erste Material bildet, und ein zweites Nanopartikel, das das zweite Material bildet, gemischt und miteinander verbunden werden.

10. Thermoelektrisches Wandlungsmodul, das eine Vielzahl von thermoelektrischen Wandlervorrichtungen und eine Elektrode umfasst, die eine elektrische Verbindung zwischen den thermoelektrischen Wandlungsvorrichtungen herstellt, wobei die Vielzahl der thermoelektrischen Wandlervorrichtungen jeweils als die thermoelektrische Wandlervorrichtung nach Anspruch 1 ausgebildet sind.

**Revendications**

1. Dispositif de conversion thermoélectrique comprenant :

un premier matériau représenté par une formule de composition $AB_x$ (dans laquelle A est au moins un élément choisi parmi le groupe consistant en Li, Na, K, Rb, Cs, Mg, Ca, Sr, Ba, Sc, Y, La, Bi, He, Ne, Ar, Kr, et Xe, et B est au moins un élément choisi parmi le groupe consistant en Zn, Cu, Ag, Au, Al, Ga, In, Si, Ge, et Sn), et ayant une conductivité thermique de réseau qui est inférieure à sa conductivité thermique électronique ; et un deuxième matériau ayant un coefficient de Seebeck supérieur au premier matériau, et une conductivité thermique électronique qui est inférieure à sa conductivité thermique de réseau, dans lequel la conductivité thermique de réseau du premier matériau est inférieure à la conductivité thermique de réseau du deuxième matériau, et dans lequel la distance de l'interface entre le premier matériau et le deuxième matériau jusqu'à une partie d'extrémité du premier matériau et jusqu'à une partie d'extrémité du deuxième matériau est 500 nm ou inférieure.

2. Dispositif de conversion thermoélectrique selon la revendication 1, dans lequel x dans la formule de composition $AB_x$ tombe dans une plage de $2 \leq x \leq 13$.

3. Dispositif de conversion thermoélectrique selon la revendication 1, dans lequel le premier matériau a une structure cristalline de type $NaZn_{13}$, une structure cristalline de type $BaCd_{11}$, une structure cristalline de type $Mg_2Zn_{11}$, une structure cristalline de type $Na_4Si_{23}$, une structure cristalline de type $CaCu_5$, une structure cristalline de type $BaZn_5$, ou une structure cristalline de type $MgCu_2$.

4. Dispositif de conversion thermoélectrique selon la revendication 1, dans lequel le premier matériau représenté par la formule de composition $AB_x$ contient La ou Ba comme un composant principal de l'élément A, et Zn ou Cu comme un composant principal de l'élément B.

5. Dispositif de conversion thermoélectrique selon la revendication 1, dans lequel le deuxième matériau est un matériau semi-conducteur contenant du silicium comme un composant principal, ou un alliage de Heusler contenant du silicium comme un composant principal.

6. Dispositif de conversion thermoélectrique selon la revendication 1, qui a une structure multicouche dans laquelle une première couche constituée du premier matériau, et une deuxième couche constituée du deuxième matériau sont stratifiées de manière alternée et jointes l'une à l'autre.

7. Dispositif de conversion thermoélectrique selon la revendication 1, qui a une structure de réseau dans laquelle le premier matériau et le deuxième matériau sont agencés de manière alternée sur le même plan, et joints l'un à l'autre.

8. Dispositif de conversion thermoélectrique selon la revendication 1, dans lequel au moins un du premier matériau et du deuxième matériau est configuré à partir d'une nanoparticule.

9. Dispositif de conversion thermoélectrique selon la revendication 8, qui est configuré comme un complexe de nanoparticules dans lequel une première nanoparticule constituant le premier matériau, et une deuxième nanoparticule constituant le deuxième matériau sont mélangées et jointes l'une à l'autre.

10. Module de conversion thermoélectrique comprenant une pluralité de dispositifs de conversion thermoélectrique, et une électrode se connectant électriquement entre les dispositifs de conversion thermoélectrique, dans lequel la pluralité de dispositifs de conversion thermoélectrique représentent chacun le dispositif de conversion thermoélectrique selon la revendication 1.

## FIG. 1

## FIG. 2

METAL :
$\kappa_{e1}$=9.7 W/mK
$\kappa_{p1}$=0.5 W/mK

SEMICONDUCTOR :
$\kappa_{e2}$=0.1 W/mK
$\kappa_{p2}$=16.4 W/mK

ELECTRON TEMPERATURE

ELECTRON TEMPERATURE

LATTICE TEMPERATURE

LATTICE TEMPERATURE

TEMPERATURE (K)

LOCATION (nm)

METAL : $\kappa_1$=10.2

SEMICONDUCTOR : $\kappa_2$=16.5

$\kappa_{eff}$=1.5 W/mK

## FIG. 3

METAL:
$\kappa_{e1}$=9.7 W/mK
$\kappa_{p1}$=0.5 W/mK

SEMICONDUCTOR:
$\kappa_{e2}$=0.1 W/mK
$\kappa_{p2}$=16.4 W/mK

ELECTRON TEMPERATURE

ELECTRON TEMPERATURE

LATTICE TEMPERATURE

LATTICE TEMPERATURE

TEMPERATURE (K)

LOCATION (nm)

METAL: $\kappa_1$=10.2

SEMICONDUCTOR: $\kappa_2$=16.5

$\kappa_{eff}$=10.7 W/mK

17

## FIG. 4

NaZn13 structure

Na

Zn

# FIG. 5A

# FIG. 5B

# FIG. 6

LATTICE THERMAL CONDUCTIVITY OF $BaCu_{13}$

# FIG. 7

BaCd$_{11}$ structure

Ba  Cd

## FIG. 8

Mg₂Zn₁₁ structure

## FIG. 9

Na₄Si₂₃ structure

## FIG. 10

CaCu5 structure

Ca

Cu

## FIG. 11

MgCu2 structure

Cu

Mg

## FIG. 12A

## FIG. 12B

## FIG. 12C

## FIG. 13A

## FIG. 13B

## FIG. 14

# FIG. 15A

# FIG. 15B

# FIG. 16A

1. Si NANOWIRE

503
502
501

# FIG. 16B

2. RESIST APPLICATION

503
502
501   504

# FIG. 16C

3. LITHOGRAPHY   503

501   504   502

## FIG. 16D

4. ION DOPING OR SPUTTERING

## FIG. 16E

5. THERMOELECTRIC CONVERSION NANOWIRE

FIG. 17

## FIG. 18

## FIG. 19

**REFERENCES CITED IN THE DESCRIPTION**

**Patent documents cited in the description**

- JP 2012104558 A
- JP 2004253618 A

- US 20030099279 A1

**Non-patent literature cited in the description**

- *Phys. Rev. B,* 2008, vol. 77 (075133), 075133-4